(19) Europäisches Patentamt
European Patent Office
Office européen des brevets

(11) **EP 1 932 008 B1**

(12) **FASCICULE DE BREVET EUROPEEN**

(45) Date de publication et mention de la délivrance du brevet:
**13.11.2019 Bulletin 2019/46**

(21) Numéro de dépôt: **06820157.3**

(22) Date de dépôt: **06.10.2006**

(51) Int Cl.:
***G01R 33/02*** *(2006.01)*

(86) Numéro de dépôt international:
**PCT/FR2006/002248**

(87) Numéro de publication internationale:
**WO 2007/042646 (19.04.2007 Gazette 2007/16)**

(54) **CAPTEURS DE CHAMP MAGNETIQUE ET DE COURANT, ET PROCEDE DE COMMANDE DE CES CAPTEURS**

STROM- UND MAGNETFELDSENSOREN UND STEUERVERFAHREN FÜR DIESE SENSOREN

CURRENT AND MAGNETIC FIELD SENSORS, AND CONTROL METHOD OF THESE SENSORS

(84) Etats contractants désignés:
**AT BE BG CH CY CZ DE DK EE ES FI FR GB GR HU IE IS IT LI LT LU LV MC NL PL PT RO SE SI SK TR**

(30) Priorité: **07.10.2005 FR 0510278**

(43) Date de publication de la demande:
**18.06.2008 Bulletin 2008/25**

(73) Titulaire: **Neelogy**
**94230 Cachan (FR)**

(72) Inventeur: **LENGLET, Luc Lucien Marie**
**92300 Levallois-Perret (FR)**

(74) Mandataire: **IPAZ**
**Parc Les Algorithmes, Bâtiment Platon**
**CS 70003 Saint-Aubin**
**91192 Gif-sur-Yvette Cedex (FR)**

(56) Documents cités:
**EP-A1- 0 577 469     FR-A- 2 687 478**
**US-B1- 6 670 809**

- **AFANAS'EV Y V: "ON THE THEORY OF FLUX GATES WITH OUTPUT AT FUNDAMENTAL FREQUENCY" MEASUREMENT TECHNIQUES, CONSULTANTS BUREAU. NEW YORK, US, vol. 42, no. 3, mars 1999 (1999-03), pages 283-292, XP000924107 ISSN: 0543-1972**

**Description**

La présente invention concerne des capteurs de champ magnétique et de courant, un procédé de commande et un noyau magnétique pour ces capteurs.

Les capteurs de champ magnétique trouvent de nombreuses applications dans l'industrie. Par exemple, ils sont utilisés pour réaliser des mesures de courant dans le domaine de l'automobile ou de l'aéronautique.

Les capteurs de champ utilisent souvent un noyau magnétique pour concentrer le flux magnétique sur le transducteur afin d'amplifier le signal.

En général le matériau magnétique dans lequel est réalisé le noyau introduit des non linéarité indésirables de types hystérésis qui perturbent la mesure et nécessitent un fonctionnement à champ nul, par la technique classique de la rétroaction de flux.

Certains noyaux magnétiques sont également utilisés comme transducteurs ou modulateurs de champ magnétique. Ces noyaux doivent alors présenter de fortes non linéarités, caractérisées par une perméabilité relative qui varie en fonction du champ magnétique. Les matériaux classiquement utilisés pour réaliser ces noyaux sont des alliages magnétiques doux. Pour contrôler les problèmes d'hystérésis, on utilise des alliages isotrope (par exemple des mu-métaux ®) ou des alliages anisotropes du type ruban nanocristallin orienté. Quel que soit le matériau, on utilise un champ d'excitation qui va plus ou moins saturer le matériau. En effet, la saturation du matériau magnétique crée un point d'inflexion important dans le cycle magnétique B(H) de ces matériaux. Ce point d'inflexion est la non linéarité qui est utilisée pour moduler le champ magnétique. Plus précisément, la présence d'un champ externe à mesurer va accroître la saturation et ainsi générer des harmoniques qui seront détectées. On peut aussi dire que le champ externe est utilisé pour moduler le champ d'excitation.

Il existe donc des capteurs de champ magnétique ayant :

- au moins un noyau magnétique apte à moduler l'amplitude d'un champ magnétique d'excitation en fonction de l'amplitude du champ magnétique à mesurer, ce noyau magnétique présentant un cycle magnétique de l'induction magnétique en fonction du champ magnétique dépourvu d'hystérésis dans une plage de fonctionnement $[H_{min} ; H_{max}]$, et
- un circuit électronique solidaire du noyau magnétique et apte à mesurer le champ magnétique induit dans le noyau magnétique, ce champ magnétique induit résultant de la combinaison du champ magnétique à mesurer et du champ magnétique d'excitation.

Lorsque le matériau est saturé, la perméabilité relative chute brusquement et le noyau perd alors son pouvoir de concentration du flux.

L'invention vise à remédier à cet inconvénient en proposant un capteur de champ magnétique utilisant un noyau magnétique pour moduler le champ d'excitation en fonction du champ magnétique à mesurer sans qu'il soit nécessaire de saturer le noyau magnétique.

L'invention a donc pour objet un capteur de champ magnétique selon la revendication 1 pour laquelle le cycle magnétique du noyau magnétique se caractérise en ce que la valeur absolue de la dérivée troisième de l'induction magnétique par rapport au champ magnétique est maximale pour un champ magnétique nul.

Il a été découvert que les noyaux magnétiques présentant la propriété du cycle magnétique ci-dessus, présente une non linéarité suffisamment importante autour du champ magnétique nul pour permettre de moduler l'amplitude du champ magnétique d'excitation par l'amplitude du champ magnétique à mesurer sans qu'il soit nécessaire pour cela de saturer le noyau magnétique. EP0577469 décrit un capteur de champ magnétique comportant au moins un noyau magnétique dans lequel sont noyées de particules de matériau superparamagnétique.

Les modes de réalisation de ce capteur peuvent comporter une ou plusieurs des caractéristiques suivantes :

- le circuit électronique est apte à générer un champ magnétique d'excitation et/ou un champ magnétique de contre réaction propre à maintenir en permanence l'amplitude du champ magnétique induit dans la plage de fonctionnement $[H_{min} ; H_{max}]$ située autour de 0 et dans laquelle le noyau magnétique n'est jamais saturé.
- le noyau magnétique est un noyau superparamagnétique.
- le circuit électronique comporte au moins un transducteur propre à convertir le champ magnétique induit dans le noyau magnétique en une tension ou un courant électrique, ce transducteur comportant à cet effet une surface sensible destinée à être exposée au flux du champ magnétique induit, et le noyau magnétique est conformé pour concentrer le flux magnétique du champ magnétique à mesurer sur cette surface sensible ;
- le transducteur est noyé à l'intérieur du noyau magnétique ;
- le circuit électronique comporte au moins un bobinage d'excitation apte à créer le champ d'excitation, ce ou chacun des bobinages d'excitation étant noyé à l'intérieur du noyau magnétique ;
- le noyau comporte :

  - un corps magnétique dans lequel est ménagé un logement propre à recevoir un conducteur électrique rayonnant le champ magnétique à mesurer,
  - un fermoir magnétique déplaçable entre une position ouverte dans laquelle le conducteur peut être introduit dans le logement, et une position fermée dans laquelle le conducteur est maintenu dans le logement, et

- un mécanisme de fermeture propre à maintenir le fermoir dans sa position fermée, ce mécanisme étant venu de matière d'un côté avec le fermoir et de l'autre côté avec le corps ;

- un logement traversant et un passage d'accès à ce logement sont formés dans le noyau magnétique, le logement étant apte à recevoir un conducteur électrique rayonnant le champ magnétique à mesurer, et le passage d'accès étant suffisamment étroit en absence de sollicitation extérieure pour retenir le conducteur à l'intérieur du logement, et sous l'action d'une force extérieure, le noyau est déformable élastiquement pour permettre l'agrandissement du passage par déformation élastique réversible en fin d'introduire le conducteur à l'intérieur du logement ;
- le noyau superparamagnétique est formé d'une matrice solide dans laquelle sont dispersées des particules superparamagnétiques suffisamment espacées les unes des autres pour que le noyau soit superparamagnétique ;
- les particules superparamagnétiques représentent au moins 5% du volume de la matrice dans laquelle elles sont incorporées ;
- la matrice est un matériau plastique ;
- le circuit électronique est apte à extraire l'amplitude d'une ou plusieurs des harmoniques du champ induit multiple(s) de la fréquence du champ d'excitation, ces amplitudes extraites étant représentative du champ magnétique à mesurer.

Ces modes de réalisation du capteur de champ magnétique présentent en outre les avantages suivants :

- le fait d'empêcher la saturation du noyau magnétique assure que le noyau remplit en permanence la fonction de concentrateur de flux et permet au transducteur de fonctionner dans sa zone de réponse linéaire ;
- les propriétés magnétiques d'un noyau superparamagnétique sont fortement non linéaires bien que ne présentant pas d'hystérésis et même lorsque le champ magnétique est très inférieur au champ de saturation ;
- les propriétés magnétiques d'un noyau superparamagnétique sont moins sensibles aux déformations mécaniques qu'un noyau magnétique réalisé à partir de rubans nanocristallin orienté, ce qui facilite leur fabrication ;
- concentrer le flux magnétique sur la surface sensible du transducteur améliore la sensibilité du capteur,
- noyer le transducteur à l'intérieur du noyau magnétique permet d'isoler ce transducteur de champs magnétiques parasites extérieurs et protège le transducteur,
- noyer le bobinage d'excitation à l'intérieur du noyau magnétique protège ce bobinage et limite l'importance du champ magnétique d'excitation rayonné à l'extérieur du noyau superparamagnétique ;

- réaliser un mécanisme de fermeture venu de matière avec le noyau diminue les coûts de fabrication et limite le nombre de pièces du capteur de champ ;
- prévoir un noyau magnétique déformable élastiquement permet d'éviter le recours à des charnières pour permettre l'introduction d'un conducteur électrique à l'intérieur d'un logement traversant le noyau ;
- introduire plus de 5% en volume de particules superparamagnétiques dans la matrice améliore les propriétés magnétiques du noyau, ce qui améliore par contre coup les performances du capteur ;
- utiliser une matrice en matériau plastique facilite la fabrication du noyau superparamagnétique et allège son poids.

L'invention concerne également un capteur de courant comportant :

- le capteur de champ magnétique ci-dessus pour mesurer le champ magnétique rayonné par le conducteur électrique, ce capteur étant apte à délivrer une valeur représentative du champ magnétique rayonné, et
- un calculateur propre à établir l'intensité du courant à partir de la valeur représentative du champ magnétique rayonné.

L'invention concerne également un procédé de commande du capteur de champ magnétique ci-dessus comportant une étape de génération d'un champ d'excitation et/ou d'un champ de contre réaction propre à maintenir en permanence l'amplitude du champ magnétique induit dans le noyau dans la plage de fonctionnement $[H_{min} ; H_{max}]$ située autour de 0 et dans laquelle le noyau magnétique n'est jamais saturé.

L'invention sera mieux comprise à la lecture de la description qui va suivre, donnée uniquement à titre d'exemple et faite en se référant aux dessins sur lesquels :

- la figure 1 est une illustration schématique de l'architecture d'un capteur de courant incorporant un capteur de champ magnétique,
- la figure 2 est une vue en perspective d'un premier mode de réalisation d'un noyau superparamagnétique du capteur de la figure 1,
- la figure 3A est un graphique représentant l'évolution de l'induction magnétique ($\vec{B}$) en fonction du champ magnétique induit ($\vec{H}$) dans le noyau de la figure 2,
- la figure 3B est un graphique représentant l'évolution de la dérivée seconde de l'induction magnétique ($\vec{B}$) en fonction du champ magnétique induit ($\vec{H}$) dans le noyau de la figure 2,
- la figure 3C est un graphique représentant l'évolution de la perméabilité relative du noyau de la figure 2 en fonction du champ magnétique induit dans ce noyau,

- la figure 4 est un organigramme d'un procédé de commande du capteur de la figure 1,
- la figure 5 est un graphique représentant un second mode de réalisation d'un noyau superparamagnétique, et
- la figure 6 représente un autre mode de réalisation d'un capteur de courant utilisant un capteur de champ magnétique.

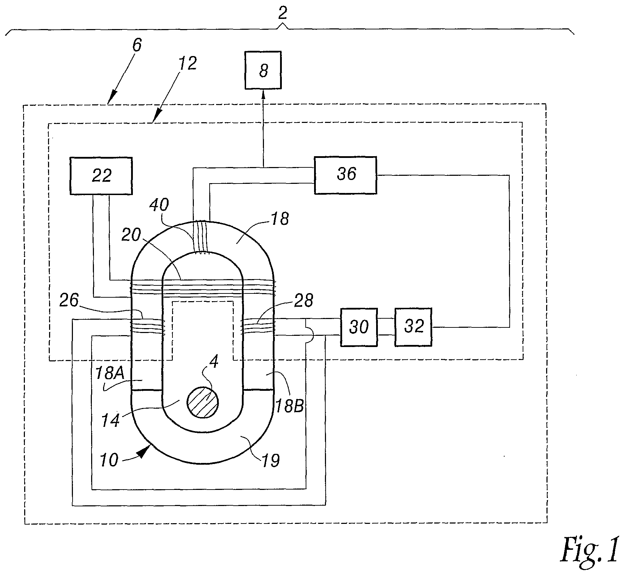

La figure 1 représente un capteur 2 du courant circulant dans un conducteur électrique 4. Ce capteur 2 comprend un capteur 6 du champ magnétique $H_m$ rayonné par le conducteur 4 et un calculateur 8 propre à établir l'intensité du courant circulant dans le conducteur 4 à partir du champ magnétique mesuré par le capteur 6.

Le capteur 2 est, par exemple, une pince ampèremétrique.

Le capteur 6 est équipé d'un noyau magnétique 10 et d'un circuit électronique 12 fixé au noyau 10. Le noyau 10 est, de préférence, un noyau superparamagnétique.

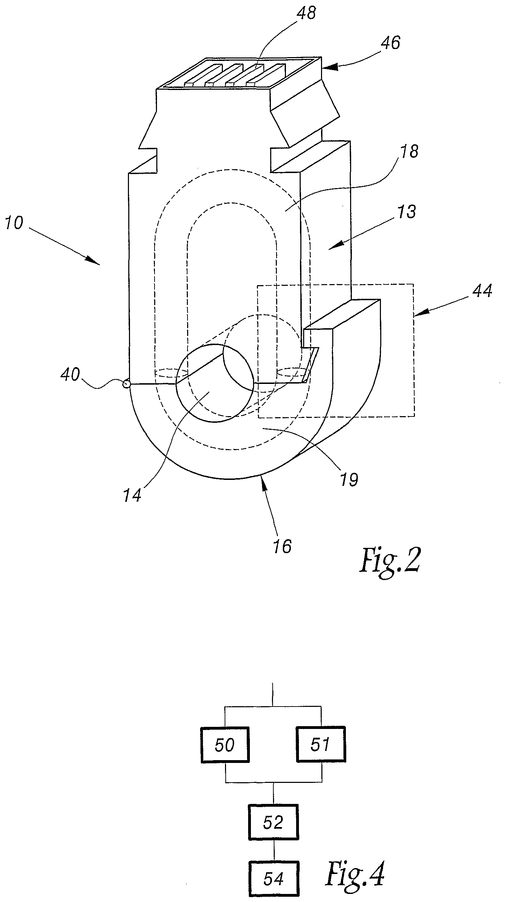

Le noyau 10 entoure le conducteur 4 de sorte que la mesure de champ magnétique est indépendante de la position du conducteur. A cet effet, le noyau 10 est formé d'un corps superparamagnétique 13 (figure 2) dans lequel est ménagé un logement 14 destiné à recevoir le conducteur 4, et d'un fermoir superparamagnétique 16. Le fermoir 16 est déplaçable entre une position ouverte dans laquelle le conducteur 4 peut être introduit dans le logement 14 et une position fermée dans laquelle le conducteur 4 est maintenu dans le logement 14.

Ici, le corps 13 est formé d'une âme superparamagnétique 18 en forme de « U » présentant deux jambes verticales 18A et 18B.

De même, le fermoir 16 est formé d'un arceau superparamagnétique 19. Le fermoir 16, lorsqu'il est en position fermée, raccorde magnétiquement les extrémités libres de l'âme 18 aux extrémités libres de l'arceau 19, de manière à former un circuit fermé en matériau superparamagnétique entourant le logement 14.

L'âme 18 et l'arceau 19 sont réalisés dans le même matériau superparamagnétique.

Pour simplifier la figure 1, seule l'âme 18 et l'arceau 19 sont représentés.

D'autres détails du noyau 10 seront décrits ci-dessous en regard de la figure 2.

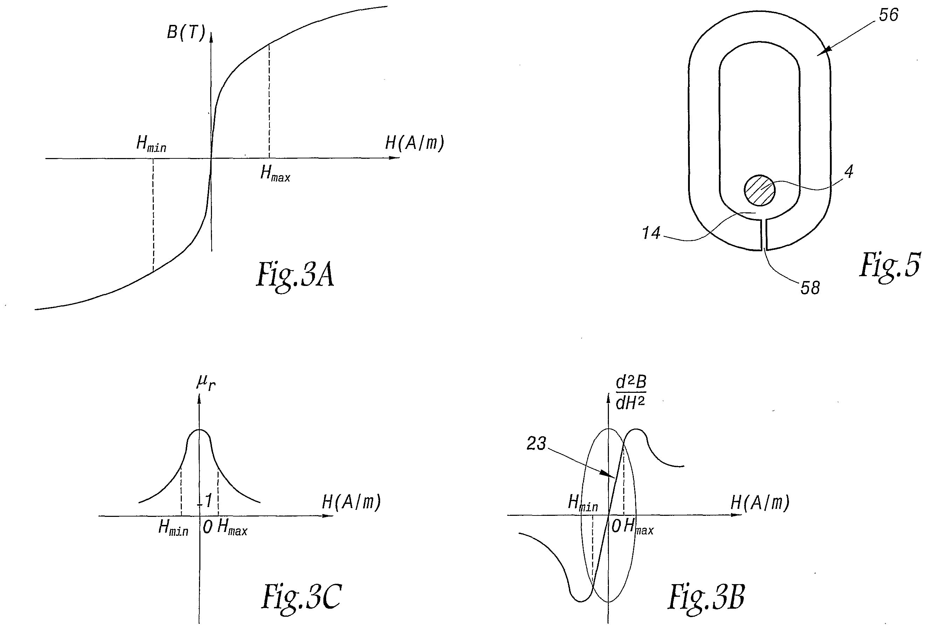

Un noyau superparamagnétique présente un cycle magnétique B(H) dont un exemple typique est représenté dans le graphe de la figure 3A. Sur la figure 3A, l'axe des abscisses représente le champ magnétique H en ampères par mètre et l'axe des ordonnées représente l'induction magnétique B en Tesla.

La figure 3B représente quant à elle l'évolution en fonction du champ magnétique H de la dérivée seconde de l'induction magnétique B. Cette dérivée seconde présente une pente 23 (entourée par une ellipse) quasiment linéaire et fortement inclinée. Cette pente 23 est centrée sur la valeur nulle du champ magnétique H et comprise entre des bornes $H_{min}$ et $H_{max}$.

La figure 3C donne un exemple typique des variations de la perméabilité relative en fonction du champ magnétique induit dans le noyau 10. Ces variations sont non linéaires, et plus précisément paraboliques, entre les bornes $H_{min}$ et $H_{max}$.

Un matériau superparamagnétique se caractérise par le fait que :

1) il ne présente pas de rémanence magnétique, de sorte que l'induction magnétique B est nulle ou quasiment nulle lorsque le champ magnétique H est nul ;
2) il ne présente pas d'hystérésis, de sorte que la courbe de magnétisation est confondue avec la courbe de démagnétisation dans le cycle magnétique B(H) ;
3) la perméabilité relative varie continûment et de façon non linéaire en fonction du champ magnétique ;
4) le cycle magnétique B(H) présente la même allure et les mêmes propriétés quelle que soit la direction du champ magnétique H ; et
5) la valeur absolue de la dérivée troisième de l'induction magnétique B par rapport au champ magnétique H présente un maximum lorsque le champ magnétique H est nul.

La caractéristique 2) différencie les matériaux superparamagnétiques d'alliages magnétiques doux tels que des mu-métaux ®.

La caractéristique 4) différencie les matériaux superparamagnétiques d'un ruban nanocristallin orienté puisque ce dernier ne présente un cycle magnétique B(H) sans hystérésis et sans rémanence magnétique que pour une seule direction prédéterminée du champ magnétique H. Par conséquent, l'orientation du noyau superparamagnétique vis-à-vis du champ magnétique à mesurer est sans importance, alors que ce n'est pas le cas lorsque le noyau est réalisé à l'aide d'un ruban nanocristallin orientés.

La caractéristique 5) se traduit par le fait que le cycle magnétique B(H) est fortement non linéaire autour du champ magnétique nul. Il en résulte également que la pente 23 est fortement inclinée. Ainsi, une faible variation du champ magnétique H se traduit par une variation importante de la dérivée seconde de l'induction magnétique B et également par une variation importante de l'amplitude des harmoniques paires dans le signal mesuré. Les harmoniques paires sont définies comme étant les harmoniques dont la fréquence est un multiple entier N de la fréquence du champ magnétique d'excitation, N étant un nombre paire. Ceci explique que le capteur 6 présente une très bonne sensibilité vis-à-vis des variations du champ magnétique à mesurer autour du champ magnétique nul.

De plus, la pente 23 est linéaire ou quasiment linéaire sur la plage de fonctionnement du capteur 6, de sorte que la conversion du signal mesuré en une valeur de champ magnétique est simplifiée.

Ici, le matériau superparamagnétique utilisé pour réaliser l'âme 18 et l'arceau 19 comprend une matrice solide dans l'épaisseur de laquelle sont incorporées des particules superparamagnétiques. Les particules superparamagnétiques sont, par exemple, des particules ferromagnétiques dont la largeur la plus grande est suffisamment petite pour que celles-ci, prise individuellement, présentent un cycle magnétique B(H) ayant les mêmes propriétés que celui de la figure 3. Typiquement, la plus grande largeur des particules ferromagnétiques est choisie inférieure à 100 nanomètres et le plus souvent inférieure à 20 nanomètres. Cette plus grande largeur de la particule ferromagnétique en deçà de laquelle elle devient superparamagnétique est fonction du matériau ferromagnétique utilisé. Le superparamagnétisme ainsi que des particules superparamagnétiques sont présentés dans la référence bibliographique suivante : E. du Trémolet de lacheisserie et coll « Magnétisme » TOM 1, Presses Universitaire de Grenoble, 1999.

Les oxydes de fer sont les particules superparamagnétiques préférées. Pour être plus complet, on peut préciser que les particules superparamagnétiques peuvent être choisies parmi les oxydes de fer et les oxydes mixtes de fer et d'un autre métal, notamment choisi parmi Mn, Ni, Zn, Bi, Cu, Co. Les oxydes de fer $Fe_3O_4$ et $Fe_2O_3$ sont des modalités préférées. On peut aussi utiliser : des perovskites ayant des propriété superparamagnétiques, en particulier des perovskites à base de Fe, des oxydes superparamagnétiques de nickel, de cobalt ou des oxydes mixtes de ces métaux, ou encore des alliages métalliques superparamagnétiques, e.g. de type FeNi, CoNi, en particulier $Fe_{20}Ni_{80}$.

La matrice solide est choisie pour ne pas perturber les propriétés magnétiques des particules superparamagnétiques. Par exemple, la matrice solide est uniquement diamagnétique.

On notera également que par le terme « solide », on désigne ici également des matrices en matière déformable élastiquement de façon réversible, telles que des élastomères.

Les différentes matières susceptibles de donner lieu à une matrice solide au sens de l'invention peuvent être utilisées. De préférence, la matrice est une matière plastique, notamment choisie parmi les thermodurcissables (e.g. phénoplastes, aminoplastes, résines époxydes, polyesters insaturés, polyuréthannes réticulés, alkydes) et les thermoplastiques (e.g. polyvinyliques, chlorures de polyvinyle, acétates de polyvinyle, alcools polyvinyliques, polystyrènes et copolymères, polymères acryliques, polyoléfines, dérivés cellulosiques, polyamides), ou encore des polymères spéciaux (e.g. polymères fluorés, silicones, caoutchouc synthétiques, polyesters saturés, polyuréthannes linéaires, polycarbonates, polyacétals, oxydes de polyphénylènes, polysulfones, polyéthersulfones, polysulfures de phénylène, polyimides).

Les élastomères peuvent notamment être du type silicone ou caoutchouc synthétique.

Le choix de la matière constituant la matrice pourra être fait en fonction de l'application finale, et en particulier en fonction des conditions d'usage. Ainsi, dans l'industrie automobile, on préconise des matrices résistant aux températures d'utilisation courantes, notamment température allant de -30 °C à +150 °C. Pour l'aéronautique, la plage de température typique à laquelle la matrice doit résister va de -40°C à +100°C.

Au stade de la préparation du matériau, les particules superparamagnétiques peuvent être incorporées sous forme pulvérulente au matériau destiné à former la matrice ou à une fraction ou partie de ce matériau. Elles peuvent aussi être apportées déjà dispersées dans un milieu qui sera mélangé au matériau destiné à former la matrice, ou à une fraction ou partie de ce matériau. Dans tous les cas, le mélange doit être suffisant pour obtenir au final une dispersion adéquate des particules dans toute la matrice.

Le matériau peut être directement formé en masse, ou être obtenu à partir de billes, granulés ou analogues de matrice incluant les particules superparamagnétiques, qui sont ensuite agglomérées sous pression, frittage, fusion ou tout autre procédé adapté.

Ainsi, le matériau peut être produit par mélange du ou des constituants de la matrice avec une suspension de particules superparamagnétiques dans une phase organique miscible avec le ou les constituants de la matrice, puis polymérisation. La phase organique contenant les particules superparamagnétiques peut être formée ou comprendre un solvant organique, ou bien être formée ou comporter un ou des constituants de la matrice. A titre d'exemple, le matériau est produit par polymérisation en émulsion, e.g. les particules superparamagnétiques sont dispersées dans une phase organique contenant le ou les constituants de la matrice, puis la dispersion obtenue est mélangée avec tout ou partie d'une solution aqueuse formée d'eau et d'au moins un agent émulsifiant, puis l'ensemble est homogénéisé et enfin polymérisé. A titre d'illustration, on peut mettre en œuvre le procédé de polymérisation en émulsion décrit dans FR-A-2480764.

Ici, pour faciliter la fabrication du noyau 10, la matrice est en matière thermoplastique ou thermodurcissable.

La répartition des particules superparamagnétiques à l'intérieur de la matrice est telle que les distances entre particules superparamagnétiques sont suffisantes pour que le noyau macroscopique formé par cette matrice et les particules superparamagnétiques présente les mêmes propriétés magnétiques que les particules qui le forment.

De préférence, la répartition des particules superparamagnétiques à l'intérieur de la matrice est homogène, de manière à avoir une répartition spatiale homogène des propriétés magnétiques.

Les particules superparamagnétiques représentent un pourcentage P du volume total du noyau superparamagnétique. Typiquement, le pourcentage P est choisi supérieur à 2,5% et, de préférence supérieur à 5% ou à 15%.

Il existe un seuil L pour le pourcentage P, au-delà duquel le noyau formé par cette matrice et ces particules superparamagnétiques perd ses propriétés superparamagnétiques car les distances entre les particules superparamagnétiques sont trop courtes, de sorte que les particules superparamagnétiques sont couplées magnétiquement les unes aux autres et se comportent alors comme une particule ferromagnétique dont la plus grande largeur dépasse le seuil au-delà duquel les propriétés superparamagnétiques disparaissent.

Le pourcentage P est choisi aussi proche que possible de cette limite L sans la dépasser. Par exemple, le pourcentage P est choisi dans la plage définie par la relation suivante :

$$L-10\% \leq P \leq L-1\%.$$

Plus le pourcentage P est élevé plus la capacité du noyau 10 à concentrer le flux à mesurer est élevée, ce qui améliore les performances du capteur 6.

La perméabilité relative $\mu$ du noyau 10 est, de préférence, strictement supérieure à 1 pour concentrer le flux magnétique. Ici, la valeur maximale $\mu_{max}$ de la perméabilité relative du noyau 10 est obtenue pour une valeur nulle du champ magnétique induit dans le noyau 10. Par exemple, la valeur $\mu_{max}$ est supérieure à 1.5.

Le circuit 12 est apte à exciter à l'aide d'un champ magnétique d'excitation $H_{ex}$ le noyau 10 et à mesurer le champ magnétique induit $H_i$ dans le noyau 10 en réponse à cette excitation.

Le champ $H_{ex}$ est un champ magnétique alternatif dont la fréquence est au moins deux fois supérieure à celle du champ magnétique à mesurer. Typiquement, la fréquence du champ magnétique $H_{ex}$ est supérieure à 100 Hz et de préférence supérieur à 1 000 Hz.

L'amplitude du champ magnétique $H_{ex}$ est comprise entre les bornes $H_{min}$ et $H_{max}$.

Le circuit 12 comprend une source réglable pour créer le champ $H_{ex}$. Cette source est, par exemple, formée d'un bobinage 20 d'excitation alimenté en courant alternatif de fréquence $F_0$ par une source commandable d'alimentation 22.

Le bobinage 20 est enroulé autour de l'âme 18, de manière à ce que le champ $H_{ex}$ soit de même direction dans les jambes 18A et 18B.

Le circuit 12 comprend aussi au moins un transducteur propre à transformer le champ magnétique induit $H_i$ en réponse au champ $H_{ex}$ à l'intérieur du noyau 10 en un signal électrique tel qu'un courant ou une tension mesurable. A cet effet, le ou chacun de ces transducteurs présente une surface sensible au champ $H_i$.

Ici, le circuit 12 comporte deux transducteurs 26 et 28 sensibles aux champs $H_i$ à l'intérieur, respectivement, des jambes verticales 18A et 18B.

Par exemple, les transducteurs 26 et 28 sont des bobinages de mesure bobinés, respectivement, autour des jambes verticales 18A et 18B.

Les transducteurs 26 et 28 sont raccordés de façon différentielle à l'entrée d'un filtre passif 30. Ainsi, en absence de champ magnétique à mesurer, le signal électrique à l'entrée du filtre 30 est nul. Un tel montage différentiel des transducteurs 26 et 28 permet d'accroître la sensibilité du capteur 6.

Le filtre 30 permet d'effectuer un pré-filtrage pour supprimer du signal électrique mesuré les harmoniques qui n'ont pas d'intérêt pour la suite du traitement.

La sortie du filtre 30 est raccordée à l'entrée d'un démodulateur d'amplitude 32 propre à extraire une ou plusieurs des harmoniques du signal reçu en entrée dont les fréquences sont des multiples de $F_0$, $F_0$ étant la fréquence du champ d'excitation. De préférence, si une seule harmonique est mesurée, la fréquence de l'harmonique extraite est $N.F_0$, où N est un nombre pair pour faciliter le traitement du signal. Par exemple, ici, N est égal à 2.

Le filtre 32 est, par exemple, un détecteur synchrone raccordé à la source d'alimentation 22.

Le circuit 12 comprend également une contre réaction en champ pour rendre le capteur 6 encore robuste vis-à-vis des variations de température et d'augmenter sa plage de linéarité.

La contre réaction en champ est également utilisée ici pour maintenir en permanence l'amplitude du champ $H_i$ dans la plage de fonctionnement $[H_{min}\,;\,H_{max}]$ située autour de 0, et de préférence centrée autour de la valeur 0. La plage de fonctionnement $[H_{min}\,;\,H_{max}]$ est représentée sur les figures 3B et 3C.

De préférence, les valeurs des bornes $H_{min}$ et $H_{max}$ sont sélectionnées pour correspondre à une plage de fonctionnement dans laquelle le noyau 10 n'est jamais saturé.

A cet effet, le circuit 12 est équipé d'un régulateur 36 dont une entrée est raccordée à une sortie du démodulateur 34 et dont des sorties sont raccordées à un bobinage 40 de contre réaction en champ. Le régulateur 36 est apte à commander le bobinage 40, de manière à ce que celui-ci crée un champ magnétique $H_c$ de contre réaction propre à annuler le champ magnétique $H_m$ à mesurer.

A cet effet, le bobinage 40 est bobiné autour de l'âme 18.

Le courant circulant dans le bobinage 40 est représentatif du champ magnétique à mesurer.

L'une des sorties du régulateur 36 est raccordée au calculateur 8.

La figure 2 représente l'aspect extérieur du noyau 10. L'âme 18, les bobinages 20 et 40 et les transducteurs 26 et 28 sont noyés à l'intérieur du corps 13. L'arceau 19 est noyé à l'intérieur du fermoir 16.

Le corps 13 et le fermoir 16 sont entièrement réalisés en matériau superparamagnétique. Par exemple, le même matériau superparamagnétique que celui de l'âme 18 et l'arceau 19 est utilisé pour réaliser l'ensemble du corps 13 et du fermoir 16.

Par exemple, le corps 13 et le fermoir 16 sont obtenus en surmoulant respectivement l'âme 18 et le fermoir 19.

Comme illustré sur la figure 2, le noyau 10 comprend également une charnière 40 pour raccorder mécaniquement une extrémité du fermoir 16 au corps 13 tout en permettant un déplacement de ce fermoir 16 entre sa position ouverte et sa position fermée.

Du côté opposé à la charnière 40, le noyau 10 comprend un mécanisme 44 de fermeture propre à maintenir le fermoir 16 dans sa position fermée. Ce mécanisme 44 est venu de matière avec le corps 13 et le fermoir 16.

Plus précisément, ici, le mécanisme 44 est formé d'un premier profil en creux et en bosses sur une surface du corps 13 et d'un second profil en creux et en bosses formé sur le fermoir 16. Les premier et second profils sont propres à coopérer l'un avec l'autre pour maintenir le fermoir 16 dans sa position fermée.

Une partie du corps 13 est également conformée pour former un connecteur 46 contenant des cosses 48. Les cosses 48 sont électriquement raccordées au bobinage 20 et 40 ainsi qu'aux transducteurs 26 et 28 noyés à l'intérieur du corps 13. Ces cosses 48 permettent de raccorder ces bobinages 20 et 40 et les transducteurs 26 et 28 aux éléments correspondants du circuit 12.

Le fonctionnement du capteur 2 va maintenant être décrit en regard du procédé de la figure 4.

Lorsqu'un courant continu ou alternatif circule dans le conducteur 4, celui-ci entraîne la création du champ magnétique $H_m$ à l'intérieur du noyau 10.

Lors d'une étape 50, le bobinage 20 crée le champ $H_{ex}$ à l'intérieur du noyau 10. En parallèle, lors d'une étape 51, le bobinage 40 crée le champ magnétique $H_c$ qui circule autour du conducteur 4 à l'intérieur du noyau 10.

Le champ magnétique induit $H_i$ à l'intérieur du noyau 10 et auquel sont sensibles les transducteurs 26 et 28 est donc le résultat de la somme vectorielle des champs $H_m$, $H_{ex}$ et $H_c$.

Lors des étapes 50 et 51, le circuit 12 génère les champs $H_{ex}$ et $H_c$ de manière à ce que l'amplitude du champ magnétique induit $H_i$ soit maintenue dans la plage $[H_{min} ; H_{max}]$. Ainsi, le noyau 10 n'est pas saturé et peut conserver une bonne aptitude à concentrer le flux magnétique.

Le champ magnétique induit est transformé, lors d'une étape 52, en courant par les transducteurs 26 et 28.

L'ensemble des étapes suivantes de traitement du courant produit par les transducteurs 26 et 28 afin d'obtenir une valeur de champ magnétique et l'intensité du courant circulant dans le conducteur 4 sont regroupées dans une étape 54 représentée sur la figure 4.

Le filtre 30 filtre la différence entre les courants générés par les transducteurs 26 et 28 pour obtenir un signal filtré. Le filtre 32 extrait du signal filtré l'harmonique de fréquence $N.F_0$. L'apparition de cette harmonique à la fréquence $N.F_0$ est liée à la non linéarité du cycle magnétique B(H) du noyau 10 et donc aux variations non linéaires de la perméabilité relative du noyau 10. Plus précisément, les déformations du champ $H_{ex}$ dues à ces non linéarités varient en fonction de l'amplitude du champ $H_m$. Ces déformations du champ $H_{ex}$ se traduisent par la présence d'harmoniques multiples de $F_0$ dans le champ magnétique induit mesuré par les transducteurs 26 et 28.

Le démodulateur 34 établit l'amplitude de l'harmonique de fréquence $N.F_0$.

Cette amplitude est utilisée par le régulateur 36 pour commander le bobinage 40, de manière à générer un champ $H_c$ de direction et d'amplitude opposées au champ $H_m$.

Le signal de contre réaction généré par le régulateur 36 est donc représentatif de l'amplitude A du champ $H_m$.

Le calculateur 8 délivre un signal proportionnel à l'intensité du courant circulant dans le conducteur 4, ce signal étant établi à partir de l'amplitude A.

La figure 5 représente un noyau superparamagnétique 56 susceptible d'être utilisé en lieu et place du noyau 10 dans le capteur 2. Le noyau 56 diffère du noyau 10 par le fait que la matrice utilisée pour le réaliser est non pas une matrice plastique ou thermodurcissable mais une matrice en élastomère. Dès lors, le noyau 56 est élastiquement déformable.

Un trou traversant est ménagé à l'intérieur de ce noyau 56 pour ménager le logement 14.

Un passage 58 est également ménagé dans le noyau 56 pour permettre l'introduction du conducteur 4 à l'intérieur du logement 14.

En absence de sollicitation extérieure, le passage 58 est suffisamment étroit pour retenir le conducteur 4 à l'intérieur du logement 14.

Pour introduire le conducteur 4 à l'intérieur du logement 14, le noyau 56 est élastiquement déformé pour agrandir le passage 58 sous l'action d'une force extérieure.

Ainsi, dans ce mode de réalisation, il n'est pas nécessaire de prévoir une charnière, telle que la charnière 40, ou un mécanisme de fermeture, tel que le mécanisme 44.

Les bobinages et les transducteurs sont, par exemple, incorporés à l'intérieur du noyau 56 d'une façon identique à celle décrite en regard du noyau 10.

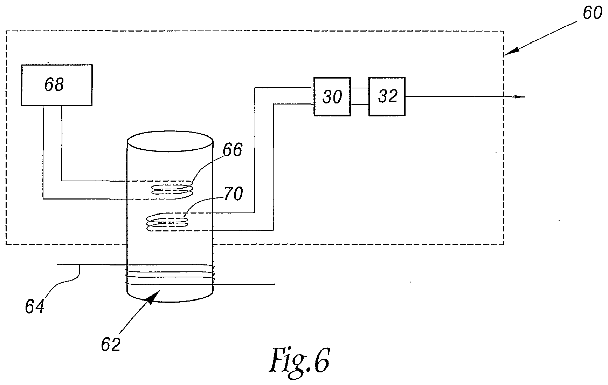

La figure 6 représente un capteur de champ 60 qui diffère du capteur 6 essentiellement par le fait qu'il comporte un noyau superparamagnétique 62 autour duquel s'entoure un conducteur 64 générant le champ magnétique à mesurer. Le fait que le conducteur 64 entoure le noyau 62 permet de rendre la mesure de champ magnétique indépendante vis-à-vis de la position du conducteur 64.

Ici, le noyau 62 incorpore une bobine d'excitation 66 raccordée à une source d'alimentation 68 identique, par exemple, à la source 22.

Le noyau 62 incorpore également une bobine 70 de mesure du champ magnétique induit à l'intérieur du noyau 62. Cette bobine 70 est, par exemple, successivement raccordée au filtre 30, au filtre 32 et au démodulateur 34. La sortie du démodulateur 34 est représentative de l'amplitude du champ magnétique mesuré.

Dans le mode de réalisation de la figure 6, la contre réaction en champ est omise. Dans ce cas là, l'amplitude du champ magnétique d'excitation est réglée au niveau de la source 68 pour que, lorsque celui-ci se combine au champ magnétique à mesurer pour former le champ magnétique induit $H_i$ à l'intérieur du noyau 62, l'amplitude du champ $H_i$ reste dans la plage $[H_{min} ; H_{max}]$. Ce réglage est, par exemple, fait de façon manuelle en fonction de connaissances préalables sur la gamme d'amplitudes du champ magnétique à mesurer.

Le fonctionnement du capteur 60 découle du fonctionnement du capteur 6 et ne sera donc pas décrit ici en détail.

De nombreux autres modes de réalisation du capteur de champ magnétique sont possibles. Par exemple, les bobines d'excitation et de mesure peuvent être confondues. De même, la bobine d'excitation et la bobine de contre réaction en champ peuvent également être confondues.

La contre réaction en champ peut être omise.

Pour diminuer les coûts, l'un des transducteurs 26 ou 28 peut être supprimé.

Dans une variante très simplifiée, le noyau superparamagnétique n'entoure pas complètement le conducteur générant le champ magnétique à mesurer.

La mesure d'harmoniques peut se résumer à une seule harmonique, dans ce cas on choisira de préférence une harmonique paire, c'est-à-dire N=2.

Les bobines ainsi que les transducteurs peuvent être noyés à l'intérieur du noyau superparamagnétique par tout type de procédé de moulage ou de surmoulage.

Les bobines peuvent aussi ne pas être noyées à l'intérieur du noyau superparamagnétique mais uniquement enroulées autour de celui-ci et fixées à ce noyau par tous moyens appropriés tels que, par exemple, à l'aide de résine adhésive.

Le mécanisme de fermeture n'est pas nécessairement venu de matière avec le fermoir et le corps. Par exemple, il peut être fixé sur le fermoir et le corps par tous types de moyens de fixation tels que, par exemple, par collage. Le mécanisme de fermeture peut également consister en une coque enserrant le corps et le fermoir et propre à maintenir le fermoir dans sa position fermée.

Le noyau superparamagnétique peut être remplacé par tout noyau réalisé dans un matériau magnétique (par exemple un composite d'alliage magnétiques doux) présentant des courbes similaires à celles des figures 3A à 3C.

Le noyau superparamagnétique est utilisé ici en même temps en tant que modulateur du champ magnétique d'excitation en fonction du champ magnétique à mesurer et en tant que concentrateur de flux magnétique. En variante, le noyau superparamagnétique peut être utilisé dans un capteur de champ magnétique uniquement en tant que modulateur ou, en alternative, en tant que concentrateur de flux.

## Revendications

1. Capteur de champ magnétique comportant :

   - au moins un noyau magnétique (10 ; 56 ; 62) présentant un cycle magnétique de l'induction magnétique en fonction du champ magnétique dépourvu d'hystérésis dans une plage de fonctionnement [Hmin ; Hmax], le cycle magnétique du noyau magnétique étant tel que la valeur absolue de la dérivée troisième de l'induction magnétique par rapport au champ magnétique est maximale pour un champ magnétique nul, **caractérisé en ce que** le noyau magnétique est apte à moduler l'amplitude d'un champ magnétique d'excitation en fonction de l'amplitude du champ magnétique à mesurer, et **en ce que** le capteur comprend en outre
   - un circuit électronique solidaire du noyau magnétique et apte à mesurer le champ magnétique induit dans le noyau magnétique, ce champ magnétique induit résultant de la combinaison du champ magnétique à mesurer et du champ magnétique d'excitation, le circuit électronique (12) comportant au moins un bobinage (20) d'excitation apte à créer le champ d'excitation.

2. Capteur selon la revendication 1 **caractérisé en ce que** le circuit électronique est apte à générer un champ magnétique d'excitation et/ou un champ magnétique de contre réaction propre à maintenir en permanence l'amplitude du champ magnétique induit dans la plage de fonctionnement [Hmin ; Hmax] située autour de 0 et dans laquelle le noyau magnétique n'est jamais saturé.

3. Capteur selon la revendication 1 ou 2, **caractérisé en ce que** le noyau magnétique est un noyau superparamagnétique .

4. Capteur selon l'une quelconque des revendications 1 à 3, **caractérisé** :

   - **en ce que** le circuit électronique comporte au moins un transducteur (26, 28) propre à convertir le champ magnétique induit dans le noyau magnétique en une tension ou un courant électrique, ce transducteur comportant à cet effet une surface sensible destinée à être exposée au flux du champ magnétique induit, et
- **en ce que** le noyau magnétique est conformé pour concentrer le flux magnétique du champ magnétique à mesurer sur cette surface sensible.

5. Capteur selon la revendication 4, **caractérisé en ce que** le transducteur (26, 28) est noyé à l'intérieur du noyau magnétique.

6. Capteur selon l'une quelconque des revendications précédentes, **caractérisé en ce que** le ou chacun des bobinages d'excitation est noyé à l'intérieur du noyau magnétique.

7. Capteur selon l'une quelconque des revendications précédentes, **caractérisé en ce que** le noyau comporte :

   - un corps (13) magnétique dans lequel est formé un logement (14) propre à recevoir un conducteur électrique rayonnant le champ magnétique à mesurer,
   - un fermoir (16) magnétique déplaçable entre une position ouverte dans laquelle le conducteur peut être introduit dans le logement, et une position fermée dans laquelle le conducteur est maintenu dans le logement, et
   - un mécanisme (44) de fermeture propre à maintenir le fermoir dans sa position fermée, ce mécanisme étant venu de matière d'un côté avec le fermoir et de l'autre côté avec le corps.

8. Capteur selon l'une quelconque des revendications précédentes, **caractérisé en ce qu'**un logement traversant (14) et un passage d'accès (58) à ce logement sont formés dans le noyau magnétique, le logement étant apte à recevoir un conducteur électrique rayonnant le champ magnétique à mesurer, et le passage d'accès étant suffisamment étroit en absence de sollicitation extérieure pour retenir le conducteur à l'intérieur du logement, et **en ce que** sous l'action d'une force extérieure, le noyau est déformable élastiquement pour permettre l'agrandissement du passage (58) par déformation élastique réversible afin d'introduire le conducteur à l'intérieur du logement.

9. Capteur selon la revendication 3, **caractérisé en ce que** le noyau superparamagnétique est formé d'une matrice solide dans laquelle sont dispersées des particules superparamagnétiques suffisamment espacées les unes des autres pour que le noyau soit superparamagnétique.

10. Capteur selon la revendication 9, **caractérisé en ce que** les particules superparamagnétiques représentent au moins 5% du volume de la matrice dans laquelle elles sont incorporées .

11. Capteur selon la revendication 9 ou 10, **caractérisé en ce que** la matrice est un matériau plastique.

12. Capteur selon l'une quelconque des revendications précédentes, **caractérisé en ce que** le circuit électronique (12) est apte à extraire l'amplitude d'une ou plusieurs des harmoniques du champ induit multiple de la fréquence du champ d'excitation, ces amplitudes extraites étant représentatives du champ magnétique à mesurer.

13. Capteur d'un courant circulant à l'intérieur d'un conducteur électrique, ce capteur comportant :

   - un capteur (2) d'un champ magnétique rayonné par le conducteur électrique, ce capteur étant apte à délivrer une valeur représentative du champ magnétique rayonné, et
   - un calculateur (8) propre à établir l'intensité du courant à partir de la valeur représentative du champ magnétique rayonné, **caractérisé en ce que** ce capteur du champ magnétique est conforme à l'une quelconque des revendications 1 à 12.

14. Procédé de commande d'un capteur de champ magnétique conforme à l'une quelconque des revendications 1 à 12, **caractérisé en ce qu'**il comporte une étape (51, 52) de génération d'un champ d'excitation et/ou d'un champ de contre réaction propre à maintenir en permanence l'amplitude du champ magnétique induit dans le noyau dans la plage de fonctionnement [Hmin ; Hmax] située autour de 0 et dans laquelle le noyau magnétique n'est jamais saturé.

**Patentansprüche**

1. Magnetfeldsensor, enthaltend:

   - zumindest einen Magnetkern (10; 56; 62), der einen Magnetzyklus der magnetischen Induktion als Funktion des Magnetfeldes ohne Hysterese in einem Betriebsbereich [Hmin; Hmax] hat, wobei der Magnetzyklus des Magnetkerns derart ist, dass der Absolutwert der dritten Ableitung der magnetischen Induktion in Bezug auf das Magnetfeld für ein Magnetfeld von null maximal ist,
   **dadurch gekennzeichnet, dass** der Magnetkern dazu geeignet ist, die Amplitude eines magnetischen Erregerfeldes in Abhängigkeit von der Amplitude des zu messenden Magnetfeldes zu modulieren, und dass der Sensor ferner
   - eine elektronische Schaltung, die fest mit dem Magnetkern verbunden und dazu geeignet ist, das im Magnetkern induzierte Magnetfeld zu messen, wobei dieses induzierte Magnetfeld aus der Kombination des zu messenden Magnetfeldes und des magnetischen Erregerfeldes resultiert, wobei die elektronische Schaltung (12) zumindest eine Erregerwicklung (20) enthält, die dazu geeignet ist, das Erregerfeld zu erzeugen, enthält.

2. Sensor nach Anspruch 1, **dadurch gekennzeichnet, dass** die elektronische Schaltung dazu geeignet ist, ein magnetisches Erregerfeld und/oder ein magnetisches Gegenreaktionsfeld zu erzeugen, das in der Lage ist, die Amplitude des induzierten Magnetfeldes im Betriebsbereich [Hmin; Hmax] dauerhaft aufrechtzuerhalten, der um 0 herum liegt und in dem der Magnetkern niemals gesättigt ist.

3. Sensor nach Anspruch 1 oder 2, **dadurch gekennzeichnet, dass** der Magnetkern ein superparamagnetischer Kern ist.

4. Sensor nach einem der Ansprüche 1 bis 3, **dadurch gekennzeichnet, dass**

     - die elektronische Schaltung zumindest einen Wandler (26, 28) enthält, der in der Lage ist, das im Magnetkern induzierte Magnetfeld in eine Spannung oder einen elektrischen Strom umzuwandeln, wobei dieser Wandler zu diesem Zweck eine empfindliche Oberfläche aufweist, die dazu bestimmt ist, dem Fluss des induzierten Magnetfeldes ausgesetzt zu werden, und dass
     - der Magnetkern dazu ausgebildet ist, den Magnetfluss des zu messenden Magnetfeldes an dieser empfindlichen Oberfläche zu konzentrieren.

5. Sensor nach Anspruch 4, **dadurch gekennzeichnet, dass** der Wandler (26, 28) im Inneren des Magnetkerns eingebettet ist.

6. Sensor nach einem der vorangehenden Ansprüche, **dadurch gekennzeichnet, dass** die bzw. jede der Erregerwicklungen im Inneren des Magnetkerns eingebettet ist.

7. Sensor nach einem der vorangehenden Ansprüche, **dadurch gekennzeichnet, dass** der Kern enthält:

     - einen Magnetkörper (13), in dem eine Aufnahmeausnehmung (14) ausgebildet ist, die in der Lage ist, einen elektrischen Leiter aufzunehmen, der das zu messende Magnetfeld abstrahlt,
     - einen Magnetverschluss (16), der zwischen einer offenen Position, in der der Leiter in die Aufnahmeausnehmung eingeführt werden kann, und einer geschlossenen Position, in der der Leiter in der Aufnahmeausnehmung gehalten wird, verlagerbar ist, und
     - einen Schließmechanismus (44), der in der Lage ist, den Verschluss in seiner geschlossenen Position zu halten, wobei dieser Mechanismus auf der einen Seite mit dem Verschluss und auf der anderen Seite mit dem Körper stoffschlüssig ausgebildet ist.

8. Sensor nach einem der vorangehenden Ansprüche, **dadurch gekennzeichnet, dass** im Magnetkern eine durchgehende Ausnehmung (14) und ein Zugangsdurchgang (58) zu dieser Ausnehmung ausgebildet sind, wobei die Ausnehmung dazu geeignet ist, einen elektrischen Leiter aufzunehmen, der das zu messende Magnetfeld abstrahlt, und der Zugangsdurchgang bei Ausbleiben einer äußeren Beaufschlagung schmal genug ist, um den Leiter im Inneren der Ausnehmung zu halten, und dass unter der Einwirkung einer äußeren Kraft der Kern elastisch verformbar ist, um die Erweiterung des Durchgangs (58) durch reversible elastische Verformung zu ermöglichen, um den Leiter in das Innere der Ausnehmung einzuführen.

9. Sensor nach Anspruch 3, **dadurch gekennzeichnet, dass** der superparamagnetische Kern aus einer festen Matrix gebildet ist, in der superparamagnetische Partikel gestreut sind, die weit genug voneinander beabstandet sind, damit der Kern superparamagnetisch ist.

10. Sensor nach Anspruch 9, **dadurch gekennzeichnet, dass** die superparamagnetischen Partikel zumindest 5% des Volumens der Matrix ausmachen, in der sie eingegliedert sind.

11. Sensor nach Anspruch 9 oder 10, **dadurch gekennzeichnet, dass** die Matrix ein Kunststoffmaterial ist.

12. Sensor nach einem der vorangehenden Ansprüche, **dadurch gekennzeichnet, dass** die elektronische Schaltung (12) dazu geeignet ist, die Amplitude einer oder mehrerer der Oberschwingungen von dem induzierten Feld zu extrahieren, die ein Vielfaches der Frequenz des Erregerfeldes sind, wobei diese extrahierten Amplituden repräsentativ für das zu messende Magnetfeld sind.

13. Sensor für einen Strom, der innerhalb eines elektrischen Leiters fließt, wobei dieser Sensor enthält:

     - einen Sensor (2) für ein vom elektrischen Leiter abgestrahltes Magnetfeld, wobei dieser Sensor dazu geeignet ist, einen für das abgestrahlte Magnetfeld repräsentativen Wert bereitzustellen, und

- einen Rechner (8), der in der Lage ist, die Stromstärke ausgehend von dem für das abgestrahlte Magnetfeld repräsentativen Wert zu bestimmen, **dadurch gekennzeichnet, dass** dieser Magnetfeldsensor einem der Ansprüche 1 bis 12 entspricht.

14. Verfahren zum Steuern eines Magnetfeldsensors nach einem der Ansprüche 1 bis 12, **dadurch gekennzeichnet, dass** es einen Schritt (51, 52) des Erzeugens eines Erregerfeldes und/oder eines Gegenreaktionsfeldes umfasst, das in der Lage ist, die Amplitude des im Kern induzierten Magnetfeldes in einem Betriebsbereich [Hmin; Hmax] dauerhaft aufrechtzuerhalten, der um 0 herum liegt und in dem der Magnetkern niemals gesättigt ist.

**Claims**

1. A magnetic field sensor comprising:

   - at least one magnetic core (10; 56; 62) exhibiting a magnetic cycle of the magnetic induction as a function of the magnetic field devoid of hysteresis in an operating span $[H_{min}; H_{max}]$, the magnetic cycle of the magnetic core being such that the absolute value of the third derivative of the magnetic induction with respect to the magnetic field is a maximum for a zero magnetic field, **characterized in that** magnetic core is able to modulate the amplitude of a magnetic excitation field as a function of the amplitude of the magnetic field to be measured, and **in that** the the sensor further comprises
   - an electronic circuit tied to the magnetic core and able to measure the magnetic field induced in the magnetic core, this induced magnetic field resulting from the combination of the magnetic field to be measured and the magnetic excitation field, the electronic circuit (12) comprising at least one excitation winding (20) able to create the excitation field.

2. The sensor as claimed in claim 1, **characterized in that** the electronic circuit is able to generate a magnetic excitation field and/or a feedback magnetic field suitable for permanently maintaining the amplitude of the induced magnetic field in the operating span $[H_{min}; H_{max}]$ situated around 0 and in which the magnetic core is never saturated.

3. The sensor as claimed in claim 1 or 2, **characterized in that** the magnetic core is a superparamagnetic core.

4. The sensor as claimed in any one of claims 1 to 3, **characterized**:

   - **in that** the electronic circuit comprises at least one transducer (26, 28) suitable for converting the magnetic field induced in the magnetic core into an electrical voltage or current, this transducer comprising for this purpose a sensitive surface intended to be exposed to the flux of the magnetic field induced, and
   - **in that** the magnetic core is devised so as to concentrate the magnetic flux of the magnetic field to be measured on this sensitive surface.

5. The sensor as claimed in claim 4, **characterized in that** the transducer (26, 28) is embedded inside the magnetic core.

6. The sensor as claimed in any one of the preceding claims, **characterized in that** this or each of the excitation windings is embedded inside the magnetic core.

7. The sensor as claimed in any one of the preceding claims, **characterized in that** the core comprises:

   - a magnetic body (13) in which is formed a housing (14) suitable for receiving an electrical conductor radiating the magnetic field to be measured,
   - a magnetic clasp (16) displaceable between an open position in which the conductor can be introduced into the housing, and a closed position in which the conductor is maintained in the housing, and
   - a closing mechanism (44) suitable for maintaining the clasp in its closed position, this mechanism being integral on one side with the clasp and on the other side with the body.

8. The sensor as claimed in any one of the preceding claims, **characterized in that** a through-housing (14) and an access passage (58) to this housing are formed in the magnetic core, the housing being able to receive an electrical conductor radiating the magnetic field to be measured, and the access passage being sufficiently narrow in the absence of exterior loading to retain the conductor inside the housing, and **in that** under the action of an exterior force, the core is deformable elastically so as to allow the enlargement of the passage (58) by reversible elastic deformation in order to introduce the conductor inside the housing.

9. The sensor as claimed in claim 3, **characterized in that** the superparamagnetic core is formed of a solid matrix in which are dispersed superparamagnetic particles spaced sufficiently far apart so that the core is superparamagnetic.

**10.** The sensor as claimed in claim 9, **characterized in that** the superparamagnetic particles represent at least 5% of the volume of the matrix in which they are incorporated.

**11.** The sensor as claimed in claim 9 or 10, **characterized in that** the matrix is a plastic.

**12.** The sensor as claimed in any one of the preceding claims, **characterized in that** the electronic circuit (12) is able to extract the amplitude of one or more of the harmonics of the field induced which is a multiple of the frequency of the excitation field, these extracted amplitudes being representative of the magnetic field to be measured.

**13.** A sensor of a current flowing inside an electrical conductor, this sensor comprising:

> - a sensor (2) of a magnetic field radiated by the electrical conductor, this sensor being able to deliver a value representative of the radiated magnetic field, and
> - a calculator (8) suitable for establishing the intensity of the current on the basis of the value representative of the radiated magnetic field, **characterized in that** this sensor of the magnetic field complies with any one of claims 1 to 12.

**14.** A method of controlling a magnetic field sensor as claimed in any one of claims 1 to 12, **characterized in that** it comprises a step (51, 52) of generating an excitation field and/or a feedback field suitable for permanently maintaining the amplitude of the magnetic field induced in the core in the operating span $[H_{min}; H_{max}]$ situated around 0 and in which the magnetic core is never saturated.

Fig. 1

48

46

18

10

13

44

40

19

14

16

*Fig.2*

50    51

52

54    *Fig.4*

14

Fig.5

Fig.3B

Fig.3A

Fig.3C

EP 1 932 008 B1

*Fig.6*

**RÉFÉRENCES CITÉES DANS LA DESCRIPTION**

**Documents brevets cités dans la description**

- EP 0577469 A

- FR 2480764 A